# EUROPEAN PATENT APPLICATION

(11) **EP 1 065 715 A2**
(43) Date of publication of application: **03.01.2001**
(21) Application number: 00401889.1
(22) Date of filing: 30.06.2000
(51) Int. Cl.: H01L 21/8249, H01L 27/06

(54) **Bicmos process with low temperature coefficient resistor (TCRL)**

(30) Priority: 01.07.1999 US 345929
(71) Applicant: Intersil Corporation, Palm Bay, Florida 32905 (US)
(72) Inventor: Hemmenway, Donald, Melbourne, FL 32935 (US); Delgado, John, Valkaria, FL 32950 (US); Butler, John, Palm Bay, FL 32907 (US); Rivoli, Anthony, Palm Bay, FL 32905 (US)
(74) Representative: Ballot, Paul

(57) **Abstract**

A low temperature coefficient resistor (TCRL) has some unrepaired ion implant damage. The damaged portion raises the resistance and renders the resistor less sensitive to operating temperature fluctuations. A polysilicon thin film low temperature coefficient resistor and a method for the resistor's fabrication overcomes the coefficient of resistance problem of the prior art, while at the same time eliminating steps from the BiCMOS fabrication process, optimizing bipolar design tradeoffs, and improving passive device isolation. A low temperature coefficient of resistance resistor (TCRL) is formed on a layer of insulation, typically silicon dioxide or silicon nitride, the layer comprising polysilicon having a relatively high concentration of dopants of one or more species. An annealing process is used for the implanted resistor which is shorter than that for typical prior art implanted resistors, leaving some intentional unannealed damage in the resistor. The planned damage gives the TCRL a higher resistance without increasing its temperature coefficient. A process for fabrication of the resistor is used which combines separate spacer oxide depositions, provides buried layers having different diffusion coefficients, incorporates dual dielectric trench sidewalls that double as a polish stop, supplies a spacer structure that controls precisely the emitter-base dimension, and integrates bipolar and CMOS devices with negligible compromise to the features of either type.

## Description

Advanced wireless communications products demand integrated circuit technologies with high performance, high levels of system integration, low power and low cost. For wireless applications up to several GHz, silicon BiCMOS technology is uniquely suited to meet these requirements. Of critical important to RF design is the availability of high quality passive components. In particular, it is desirable to have implanted thin film resistors that have a low temperature coefficient of resistance. Unfortunately, existing techniques for polysilicon thin film resistors generally result in thin film resistors with relatively large temperature coefficients of resistance.

The invention comprises a polysilicon thin film low temperature coefficient resistor and a method for the resistor's fabrication that overcome the coefficient of resistance problem of the prior art, while at the same time eliminating steps from the BiCMOS fabrication process, optimizing bipolar design tradeoffs, and improving passive device isolation. The low temperature coefficient of resistance resistor (TCRL) is formed on a layer of insulation, typically silicon dioxide or silicon nitride. The layer comprises polysilicon that has a relatively high concentration of dopants of one or more species, and has a substantial amount of unannealed implant damage. Contrary to prior art methods, the implanted resistor is annealed less than typical prior art implanted resistors in order to leave some planned unannealed damage in the resistor. The planned damage gives the TCRL a higher resistance without increasing its temperature coefficient. Thus, even though the temperature may increase, the relative value of the resistance remains the same. As such, the resistor is more precise than others produced with current methods, and may be used where precision requirements for high quality RF devices apply. A process for fabrication of the resistor is used which combines separate spacer oxide depositions, provides buried layers having different diffusion coefficients, incorporates dual dielectric trench sidewalls that double as a polish stop, supplies a spacer structure that controls precisely the emitter-base dimension, and integrates bipolar and CMOS devices with negligible compromise to the features of either type.

In order to highlight features of the invention by way of example, while showing them in their proper context, the proportions shown in the figures are not to scale.

Figures 1-19 show sequential process steps in the formation of a TCRL in a BiCMOS process.

Figures 20-25 show experimental results for the TCRL.

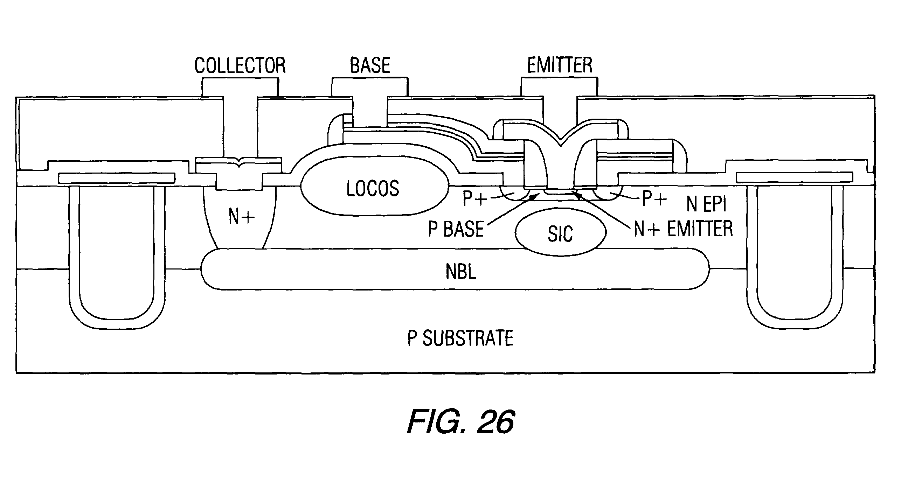

Figure 26 shows a more-detailed cross-section of the NPN bipolar device formed in the invention's BiCMOS process.

All figures show the lateral division of the regions of the substrate into CMOS regions 100, bipolar NPN regions 200, and transition regions 150 between the CMOS and bipolar regions. The regional divisions are shown by dotted lines.

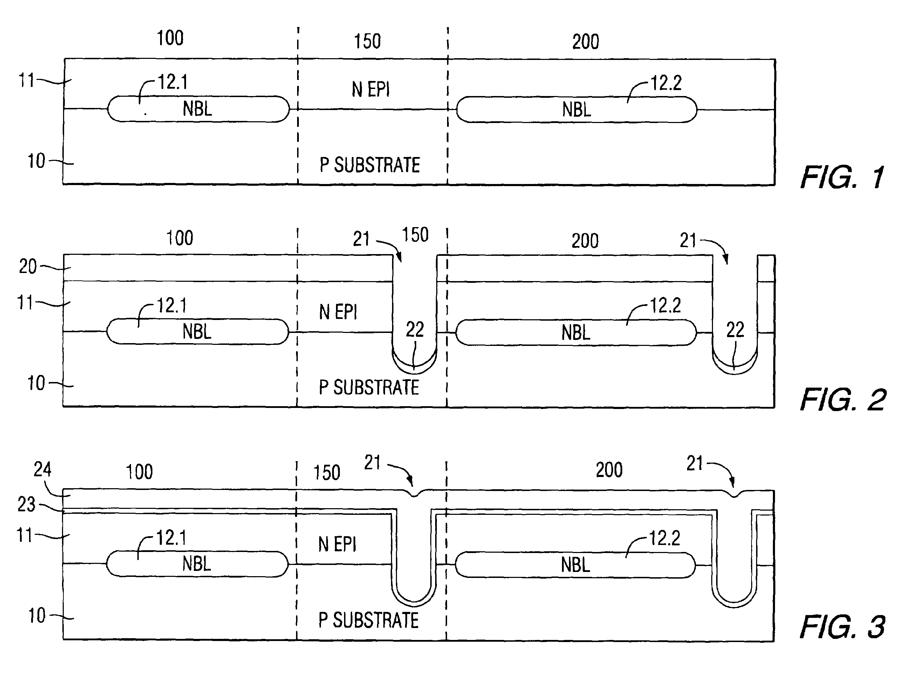

Refer first to Figure 1. A P-type substrate has its upper surface covered with a suitable ion implantation mask such as deposited oxide, thermally-grown oxide or photoresist. Openings are made in the resist mask to define the N+ buried layer regions 12.1 and 12.2. Those regions are implanted with a first N-type dopant such as Arsenic. The implantation mask is then stripped.

The substrate is then covered with a second suitable ion implantation mask such as deposited oxide, thermally-grown oxide or photoresist. Openings are made in the mask to define other buried layer regions, into which are implanted a second N-type dopant with a significantly different diffusion coefficient than the first. The two different buried layer dopants enable the fabricating of transistors with varying collector profiles, which can be tailored to address speed versus breakdown voltage tradeoffs in the RF devices. Two different collector profiles, coupled with the use of the selectively implanted collector, provide for an integrated circuit with four NPN devices.

N+ buried layers 12.1 and 12.2 are driven in with a suitable annealing operation and an N-type epitaxial layer 11 is grown on top of the substrate 10. As a result, the substrate 10 is patterned into CMOS regions 100 that are separated from bipolar NPN regions 200 by transition regions 150. The N-type buried layers 12.1 and 12.2 are formed beneath regions that will receive P-type wells. No buried layer is required for the N-type wells.

The initial trench formation step is shown in Figure 2. Isolation trenches are formed between transition region 150 and the NPN transistor region as well as in other locations as needed for improved lateral isolation. A trench photoresist mask 20 is uniformly deposited and patterned on the substrate 10. The photoresist is developed to expose the trench regions 21. A suitable wet or dry etch operation etches the trenches 21 down to a level below the N+ buried layers 12.1 and 12.2. The bottoms of the trenches are then implanted with a suitable P+ channel stop 22.

As shown in Figure 3, the next step includes stripping the photoresist 20, performing thermal oxidation on the trench sidewalls and depositing and patterning a sidewall dielectric layer 23 such as an oxide nitride sandwich. Oxidation layer 23 is densified, providing a polish stop for planarization. Nitride in this layer has the feature of closely matching the thermal characteristics of silicon. The layer is formed at a thickness which is thin enough to prevent any overhang of the trench cavity, thereby allowing complete trench fill during subsequent deposition steps. Oxidation layer 23 also provides a pad oxide for LOCOS at a later stage. The combination of thermal oxidation, oxide deposition and oxide densification allows the trench sidewall to match the thermal expansion rate of the silicon substrate.

An alternate embodiment would be to deposit the sidewall dielectric layer in such a way that would cause subsequent trench fill to form a void in the trench which is below the surface of the silicon substrate. This feature provides stress relief and eliminates silicon defect generation in the silicon adjacent the trench.

The substrate 10 is then subjected to a polysilicon deposition step that deposits a polysilicon layer 24 over the substrate 10 and epitaxial layer 11 and fills the trenches 21. The undoped polysilicon fill is a semi-insulating material, which provides a favorable electrical characteristic for RF parasitic capacitances.

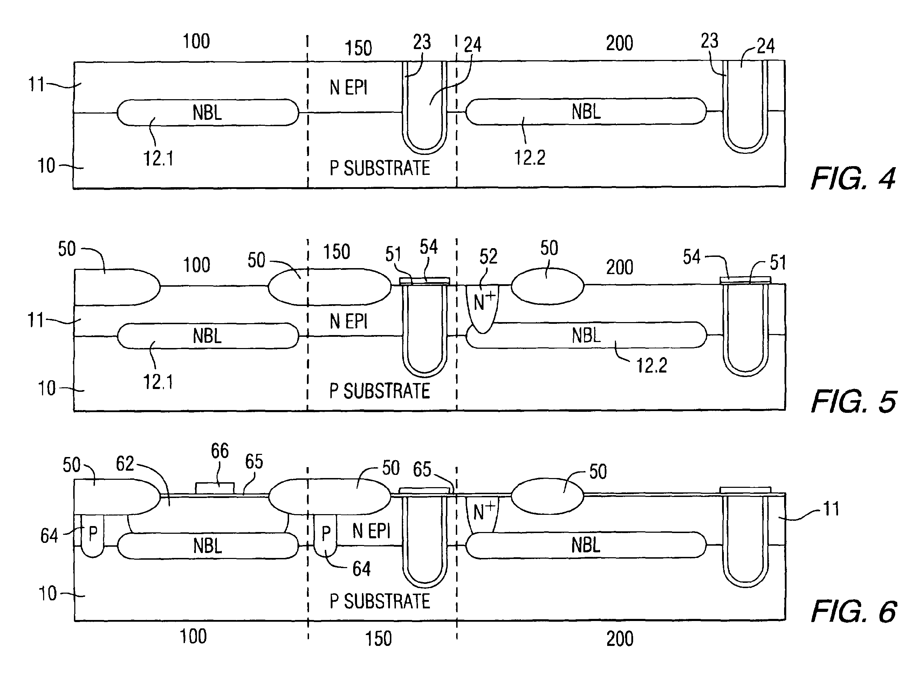

Figure 4 shows completion of the trenches. The substrate 10 and epitaxial layer 11 are planarized to remove the layers of polysilicon 24 and the thermal oxide 23 from the surface of the substrate 10 and epitaxial layer 11 in all areas except above the trenches. Such planarization is accomplished with a conventional chemical mechanical polishing operation. The nitride underneath the polysilicon serves as a hard stop during the polish operation and protects the underlying oxide and silicon from damage. The thinness of the oxide nitride sandwich also assures the precise match of the polished trench polysilicon surface to the original silicon surface.

It is important both to protect the trenches 21 and to cover the NPN region 200 during formation of the CMOS devices. Likewise, it is a goal of this process to combine as many of the CMOS and bipolar processing steps as possible. Accordingly, turning to Figure 5, the trenches are initially protected from the subsequent CMOS processing steps. This protection includes forming a pad oxide layer 51 over the trenches. Pad oxide layer 51 is followed by an N+ sinker photoresist deposition, patterning, and implantation step to form the N+ sinker 52 for the future collector of the NPN transistors 200. Next, a layer of silicon nitride 54 is deposited over the pad oxide 51 on the surface of the substrate 10 and epitaxial layer 11. The silicon nitride is initially patterned to expose local oxidation (LOCOS) regions 50. Following LOCOS patterning, a conventional LOCOS operation fabricates LOCOS regions 50 that provide surface lateral isolation of the NMOS and PMOS devices 100 and separate the sinker diffusion 52 from the rest of the NPN transistor 200. The silicon nitride is stripped from the rest of the surface of the substrate 10 and epitaxial layer 11 except for regions above the trenches 21.

During the LOCOS operation, a 'skin' layer of silicon dioxide forms on the surface of the nitride oxidation mask. This skin layer is patterned using conventional photoresist and wet etch, leaving the skin layer over the trench regions. After photoresist removal, the nitride is removed in a suitable wet etch chemistry except for regions above the trenches 21. The use of this oxide layer allows simultaneous protection of the trench areas and removal of the nitride in a manner completely benign to the underlying pad ox and silicon substrate regions. Protection of these regions from further stress-generating thermal oxidation is important to the successful fabrication of shallow transistor structures, which follows as taught in U.S. Patent #5,892,264.

The pad oxide is then removed from the surface of substrate 10 and epitaxial layer 11 to expose the surface for further fabrication.

Refer now to Figure 6. In the next step, a sacrificial oxidation is performed on the surface of epitaxial layer 11. The oxidation is a typical first step in the formation of N-wells and P-wells for the CMOS devices 100. Suitable photoresist masks and implants 62 provide the N-wells and P-wells for the CMOS devices. A heavier P-type implant 64 provides junction isolation to separate PMOS and NMOS devices. Following removal of the sacrificial oxide, a gate oxide layer 65, typically a thermal oxide, is grown on the surface of epitaxial layer 11. That step is followed by uniform, deposition of a layer of polysilicon which is subsequently patterned and doped to form polysilicon gates 66.

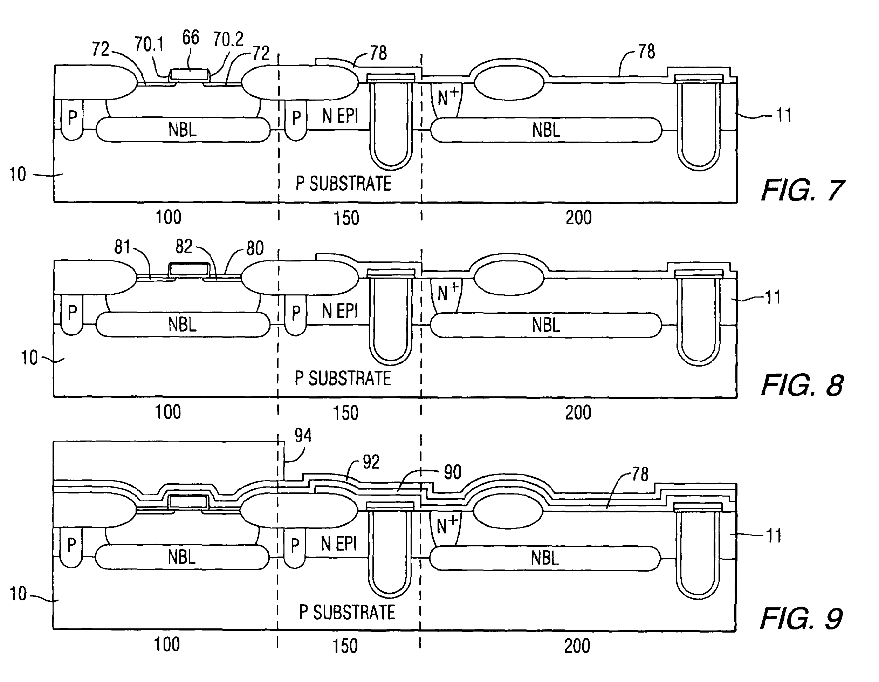

The next stage in the fabrication of the CMOS transistors is shown in Figure 7. Next, the NMOS and PMOS drains receive a typical lightly-doped drain implant 72 (N) or (P) respectively (the P-type implant is not shown here) for forming the N-type lightly-doped drain regions and the P-type lightly-doped drain regions. An annealing step drives the lightly doped drains slightly under the sidewall of the gates. The lightly doped drain regions use the sidewalls of the gate as masks. These regions are self-aligned in a conventional manner using the gate as masks followed by suitable P-type and N-type implants. Following that step, in a region not shown in the figure, a typical P+ resistor is formed in the N-type epitaxial region 11 using a suitable photoresist and implant. Next, an NPN protection spacer oxide layer 78 is uniformly deposited over epitaxial layer 11. The spacer oxide 78 covers the transition region 150 and NPN region 200 of layer 11, Without this spacer oxide coverage, subsequent CMOS processing steps would interfere with the formation of the NPN transistor. The spacer oxide layer over the gate 66 is patterned and removed to leave sidewall spacers 70.1, 70.2 at the edges of the gate 66.

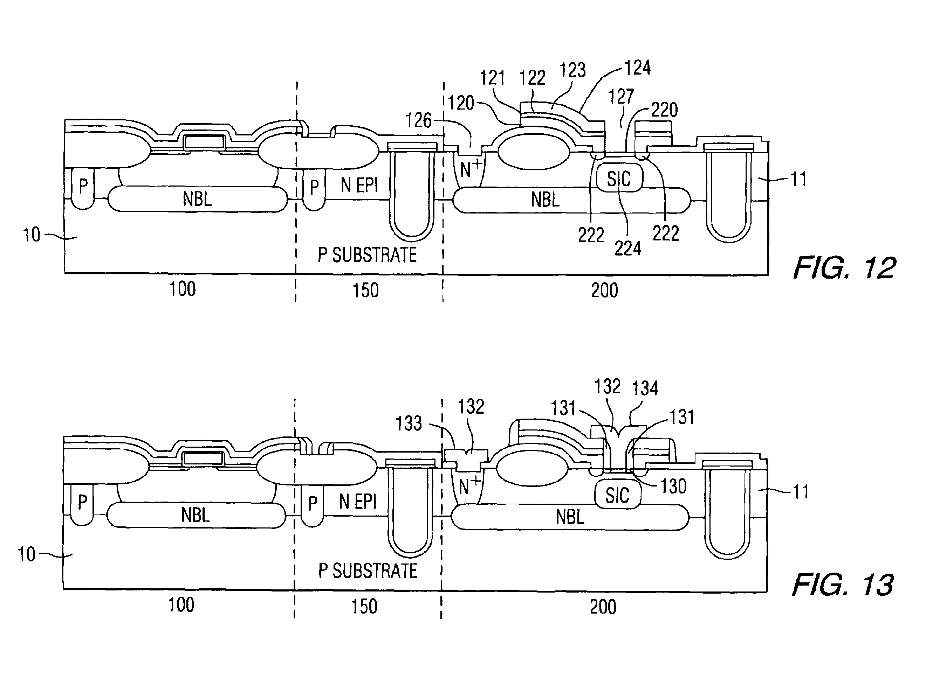

The spacer oxide layer 78 not only provides the sidewall spacers for the CMOS devices but also provides a hard mask and surface isolation for the active elements of the NPN transistor. Performing this deposition step early in the process saves one or more deposition and masking steps later in the process. As a result, the spacer oxide layer 78 forms the mask for the self aligned sources and drains of the CMOS devices and the mask for the collector and emitter openings 126, 127, respectively. See Figure 12 for these later process effects.

The next CMOS processing step is shown in Figure 8. A screen oxide layer 80 is deposited and patterned to cover the lightly doped source and drain regions of the CMOS device. Those regions are then suitably implanted with either P+ or N+ ions to form sources 81 and drains 82. The respective P-type and N-type sources and drains are then subjected to an annealing operation where the diffusion time is set to adjust the depth of the sources and drains. While the figures show only one MOS device, those skilled in the art understand that the process disclosed herein can be used to form multiple transistors including pluralities of NMOS, PMOS and bipolar devices.

Having completed the formation of the CMOS transistors, the process protects the CMOS transistors while fabricating the NPN transistors. As a first step, a CMOS nitride etch stop protection layer 90, as shown in Figure 9, is uniformly deposited over epitaxial layer 11. On top of the nitride protection layer, there is deposited a CMOS oxide protection layer 92. Since the two protection layers can be selectively etched with respect to each other, the combination of deposited layers in two sequential steps saves a substantial number of future process steps by using the two layers as different etch stops.

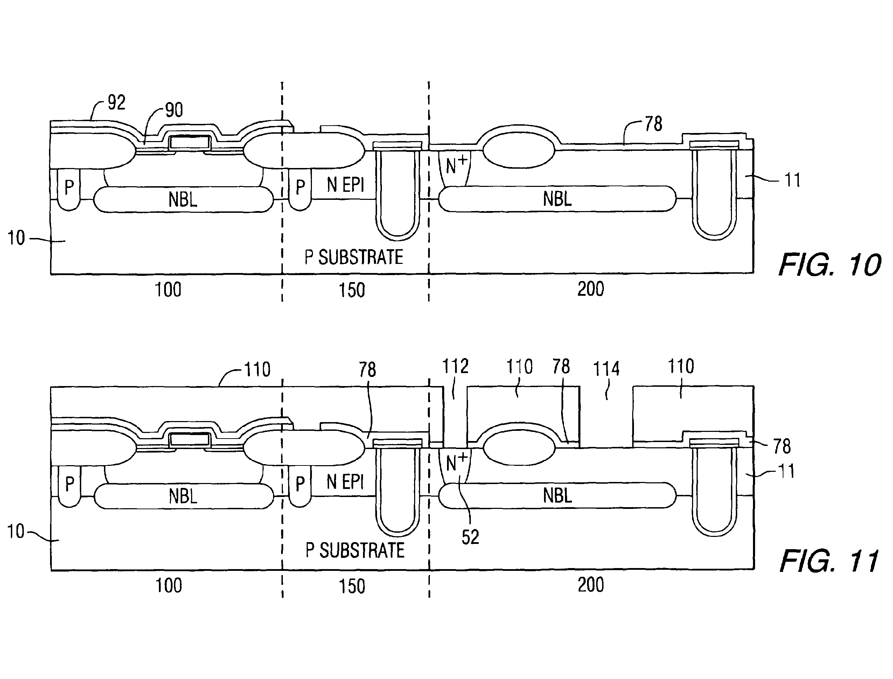

A photoresist layer 94 is deposited and patterned to cover the CMOS devices and at least part of the LOCOS region that extends from the transition region 150 into the CMOS region 100. The CMOS oxide protection layer 92 and nitride protection layer 90 are stripped from the exposed NPN region 200 using suitable wet etchings. As a result of sequential etching operations, the spacer oxide layer 78 is exposed as shown in Figure 10.

Turning to Figure 11, a thermal oxide photoresist layer 110 is uniformly deposited over spacer oxide layer 78 and patterned to have openings 112 and 114 in the NPN section 200. With the photoresist 110 in place, the spacer oxide in exposed regions 112 and 114 is removed in order to expose the surface of the sinker diffusion 52 and the surface of the subsequent NPN transistor 200.

In the formation of the NPN transistor, the process forms the extrinsic base first, then the intrinsic base, and finally the emitter. The extrinsic base comprises a stack of layers that are deposited on the epitaxial layer 11. Turning to Figure 12, these layers include a doped polysilicon layer 120, a tungsten silicide layer 121, a polysilicon cap layer 122, an inter-poly oxide layer 123 and a titanium nitride anti-reflective coating 124. The polysilicon layer 120, WSi layer 121 and polysilicon cap layer 122 are deposited followed by an implant of boron that will form the doping for the extrinsic base 222. The polysilicon cap layer is included to prevent the boron doping from segregating heavily at the top of the poly/ WSi layer and not adequately diffusing into the silicon to create the extrinsic base. It also prevents unwanted sputtering of the WSi layer during the boron implant, which could potentially contaminate the implant tool with heavy metallics.

The stack is suitably patterned to form the emitter opening 127. As a result of thermal processing, dopants from layer 120 form the extrinsic base 222. A further boron implant through the emitter opening forms the intrinsic base 220. With the patterning mask for the stack still in place, a SIC (Selectively Implanted Collector) implant 224 is also made through the intrinsic base 220 and the emitter hole 127. The stack pattern mask helps mask the high energy SIC implant and creates a perfect self-alignment of the SIC to the transistor. The SIC implant 224 contacts the N+ buried layer 12.2. The SIC implant 224 is annealed, the emitter surface is oxidized and a P-type implant completes the intrinsic base 220.

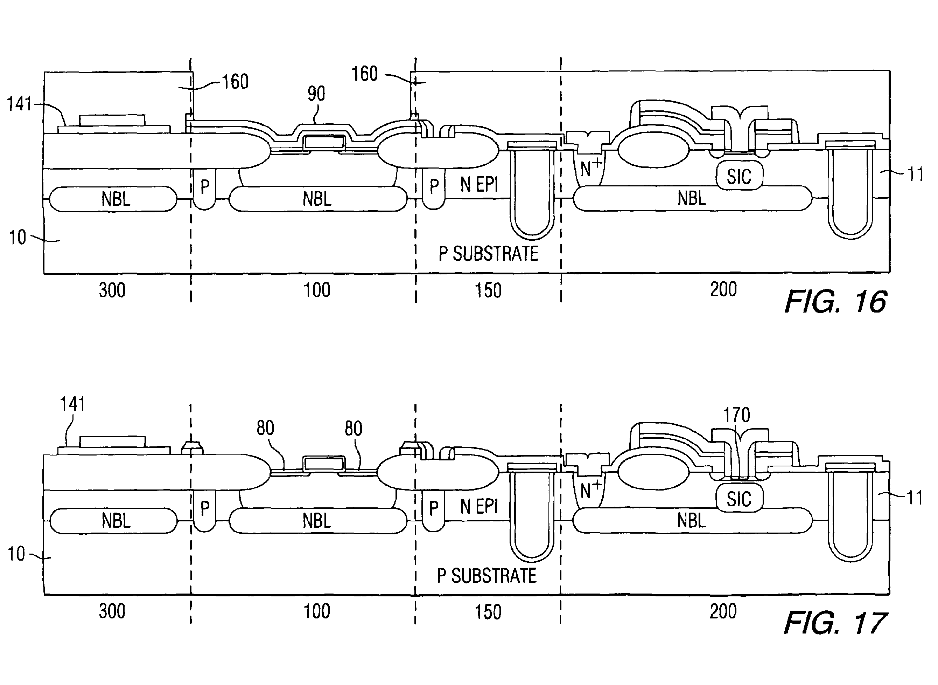

Turning to Figure 13, a layer of base spacer oxide 130 is deposited to mask the base region. A nitride spacer layer 131 is deposited and etched to open the emitter region. The base spacer oxide is etched with suitable hydrofluoric acid. The structure of the composite spacer allows the emitter-to-extrinsic-base spacing, and hence, speed-versus-breakdown device tradeoffs, to be varied easily by changing the nitride spacer deposition thickness, the base spacer oxide etch time, or both. Next, an emitter polysilicon layer 132 is deposited and patterned to form the emitter contact 134 and the collector contact 133. In a subsequent annealing operation (see Figure 17), the N-type dopants from the emitter poly layer 132 diffuse into the surface of the epitaxial layer 11 in order to form the collector surface contact and the emitter of the NPN transistors 200.

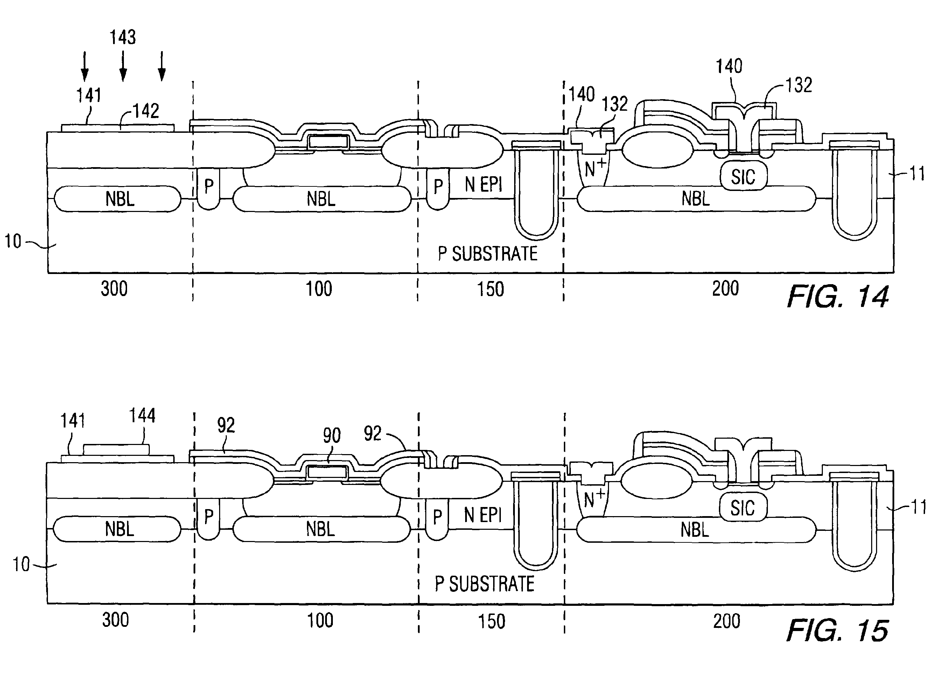

Figures 14 and 15 show the formation of the polysilicon resistor with a relatively low temperature coefficient of resistance (TCRL) resistor 141. As a first step, a protective oxide 140 is deposited over the emitter polysilicon layer 132. This layer protects any exposed emitter polysilicon layer 132 from etching when the TCRL regions are defined. A polysilicon layer 142 is deposited in the opening. Next, the polysilicon layer is implanted with a BF₂ implant 143. Finally, the TCRL 141 is covered with a photoresist and etched to its suitable size. As shown in Figure 15, the TCRL layer 141 is then covered with a protective oxide 144. The oxide is suitably patterned and masked to protect the underlying portion of the TCRL 141, while uncovering the contact regions of the resistor. It will be noted that the TCRL poly layer is deposited late in the process. As such, it is possible to deposit an amorphous silicon film and then adjust its resistivity by adding dopants.

This process of the invention forms a TCRL resistor 141 that has a resistance of 750 ohms per square and a temperature coefficient of resistance that is less than 100 parts per million (ppm). The resistor is formed using a non-selective BF₂ implant to dope the polysilicon layer. A 900°C rapid thermal annealing (RTA) step activates the resistor implant and sets the final doping profiles for the bipolar and MOS devices 200, 100. It will be noted that a TCRL poly layer is deposited late in the process. The invention's process deposits an amorphous silicon film and then adjusts its resistivity by adding dopants. A non-selective BF₂ implant is used to dope the film. A mask is used to clear oxide from all contact areas and a 900°C RTA step activates resistor implants to set the final doping. Resistor contacts are i consequently silicided before final back end processing.

The TCRL resistor 141 separates the resistance from temperature sensitivity. In the prior art, it was assumed that high resistivity resulted in a greater temperature sensitivity. Antecedents to the inventive process attempted to separate those two characteristics by providing a relatively thin film with dopings adjusted to set the resistivity to 750 ohms per square. As BF₂ implants approach a high level, an unanticipated and counter-intuitive increase in resistance was observed. This behavior was not observed when only boron was used to dope this film. Normal expectations were that higher implant levels would decrease resistance, not increase it. It appears that the heavier ion (BF₂) in high doses creates a large amount of damage in the polysilicon film and that this damage cannot be annealed at a ) relatively low temperature (900°C) with short thermal annealing (RTA) to activate the implants. The implant damage apparently creates additional trapping sites for carriers resulting in increased resistance at higher implant doses. It is believed that co-implantation of other ions could produce similar results making it possible to use the same high dose boron implant to produce even higher value resistors as well as emitters for PNP's or low resistivity extrinsic bases for NPN's or the sources and drains of MOS devices. In our preferred embodiment, the polysilicon layer 142 has a thickness of 70nm and may be in a range of from 65nm to 75nm. The implant concentration of boron ions 142 is 1.3 x 10¹⁶ and may be in a range from 9 x 10¹⁵ to 1.5 x 10¹⁶.

Early in the invention's development, three film thicknesses with a medium boron dose were chosen for evaluation, As shown in table 1, the thinnest film came the closest to the objective of 750 ohms per square. However, the TCRs of all cells were above the goal of 100 ppm. A second set of tests left the film thickness at the thin setting and varied the implant dose over more than one decade with the expectation that the higher doses would result in lower sheet resistances and lower TCRs.

**Table 1.**

| TCR/RS vs. Poly Thickness | | |
|---|---|---|
| **Poly Th.** | **Rs** | **TCR** |
| Thin | 650 | 228 |
| Med. | 532 | 238 |
| Thick | 431 | 292 |

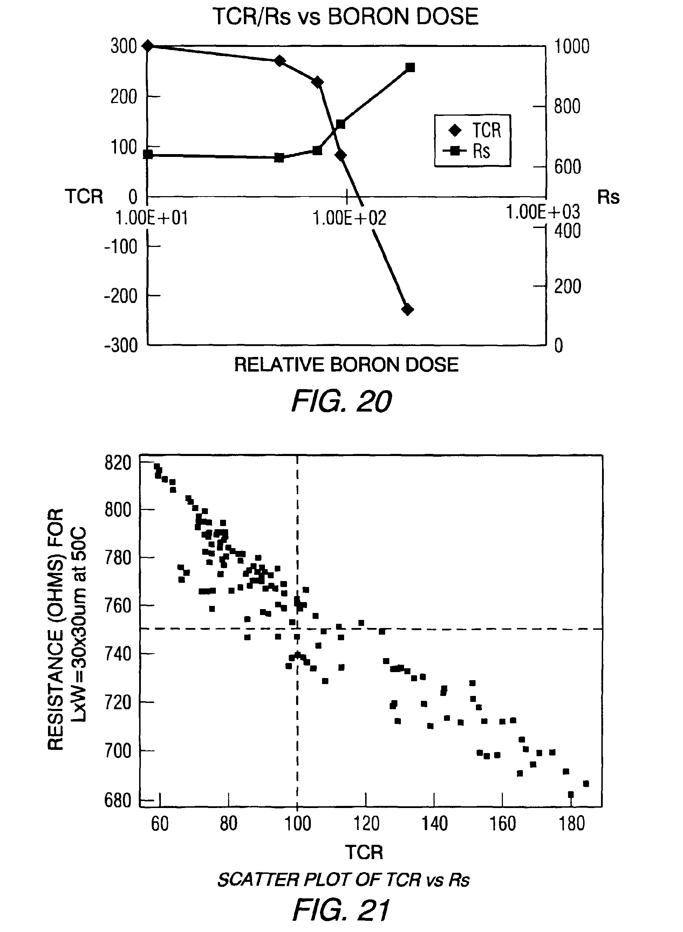

At first, as indicated in Figure 20, there was very little change in sheet resistance and TCR with increasing doses. However, as the implant levels started to approach the highest levels, an unanticipated increase in resistance was observed while the TCRs experienced a sharp decline until they became negative at the highest dose.

Yamaguchi, et al. [Yamaguchi, et al., "*Process and Device Characterization for a 30-GHz ft Submicrometer Double Poly-Si Bipolar Technology Using BF2-Implanted Base with Rapid Thermal Process",* IEEE TED, August 1993.] observed the same relationship between TCR and sheet resistance. In this study, TCRs of boron-doped P-type polysilicon resistors fabricated with a 150nm amorphous layer approach zero at sheet resistances of 600-800 ohms per square. However, within the range of doses in the cited investigation, resistance declines with increasing boron doses.

In a parallel experiment aimed at lowering TCR, boron and boron plus another species (BF₂) were implanted into a medium thickness film. The implant energies were adjusted to compensate for the different ranges of the species. The results, once again, were quite unexpected: the average resistance of the boron by itself was 200 ohms per square with a TCR of 445 ppm while the values for the BF₂ resistors were 525 and 221 respectively.

Based on these results, it is believed that the heavier ion and the extremely high doses create a large amount of damage in the polysilicon film which cannot be annealed by the relatively short 900°C RTA. This damage creates additional trapping sites for the carriers resulting in increased resistance at higher implant doses. Therefore, it is believed that co-implantation of other ions could produce similar results thus making it possible to use the same high dose boronimplantto produce high value resistors as well as the emitters for PNPs or low resistivity extrinsic bases for NPNs or the sources and drains of MOS devices.

Table 2 shows the effects of RTA temperature on sheet resistance and TCR as a function of implant dose. Once again, the higher sheet resistances obtained with the lower temperature yield reduced TCRs except at the lower dose where a resistance of 763 results in a TCR of 168.

This lends support to the theory that damage is a major part of the previously observed TCR behavior, The lower RTA temperature leads to suppressed carrier activation and higher sheets. Concurrently, there is less annealing of the implant damage. However, at the low dose, there is insufficient implant damage to degrade carrier mobility to the point where it becomes less sensitive to the temperature variations.

**Table 2.**

| TCR/RS vs. RTA Temp | | | |
|---|---|---|---|
| **Dose** | **Rs** | **TCR** | **RTA** |
| Low | 637 | 293 | 900C |
| Low | 763 | 168 | 800C |
| Med. | 628 | 271 | 900C |
| Med. | 849 | 76 | 800C |
| High | 726 | 90 | 900C |
| High | 832 | 22 | 800C |

### CHARACTERIZATION RESULTS

Figure 21 is a scatter plot of a 30 x 30 micron resistor showing the relationship of TCR to sheet resistance at 50°C was chosen as the lowest measurement point. The TCR is calculated by fitting a line to values measured from 50-125°C at 25° intervals. The dashed lines denote the objectives that were set for this development project.

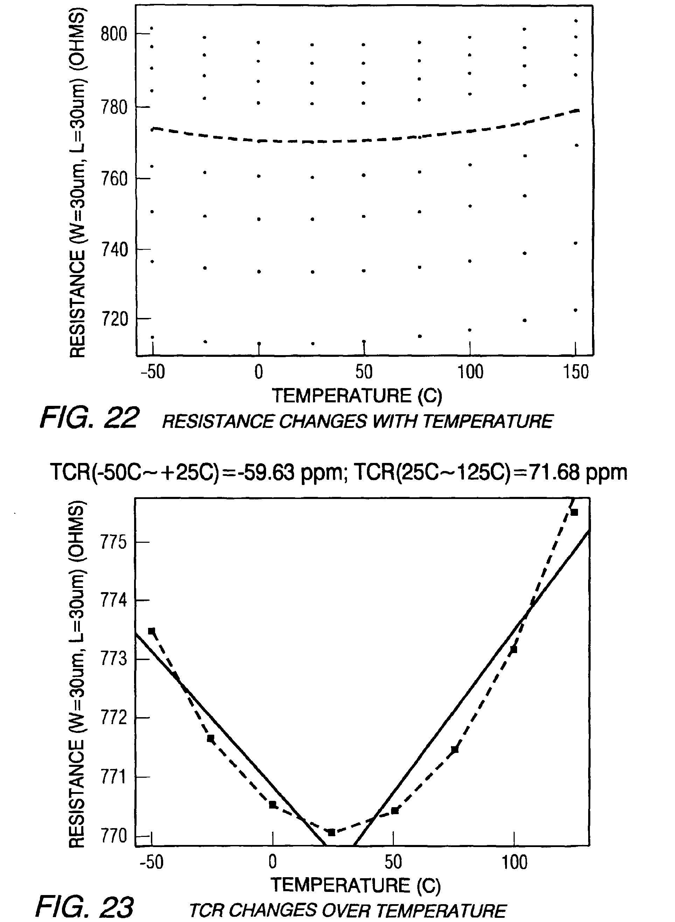

Parts from two different runs were packaged and measured from -50 to 150°C. Figure 22 shows average changes in sheet resistance for nine parts measured over this temperature range while Figure 23 is a plot of the calculated TCRs for this set of measurements. The solid line represents a linear fit while the dashed line is a polynomial fit. The upward "hook" observed at lower temperature is typical to that of diffused resistors.

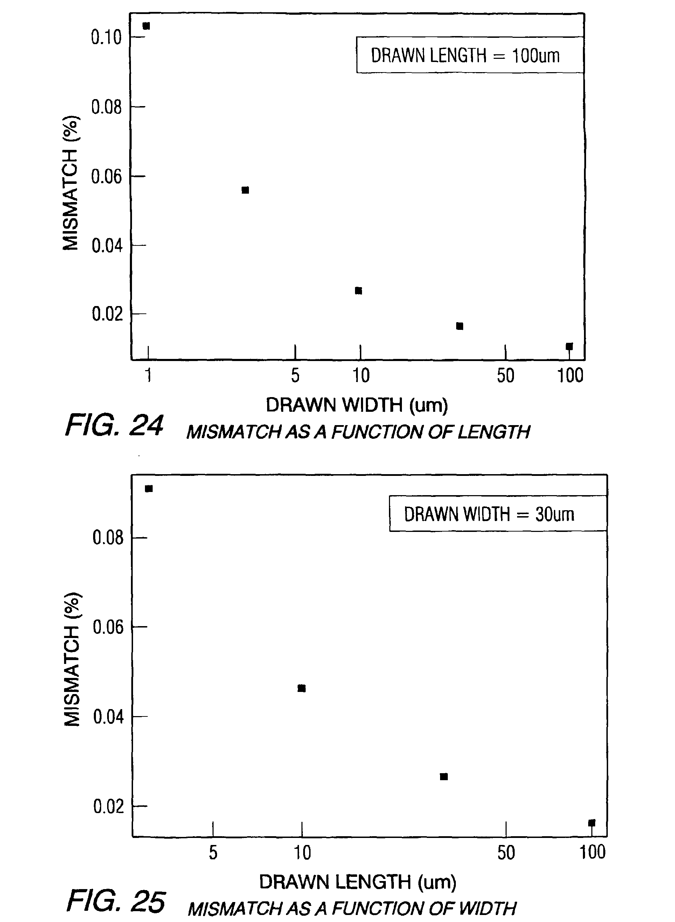

Since matching is of particular interest to analog and mixed signal designers, Figure 24 shows the percent mismatch as a function of length for a fixed width resistor and Figure 25 represents the same parameter as a function of width with a fixed length. The data, as expected, show improved matching with increasing dimensions.

The feasibility of fabricating a high value polysilicon resistor with low TCR has been demonstrated. The investigation has uncovered a relationship between ion species, sheet resistance and TCR which can result in reduced process complexity, Since 800°C RTA is a benign temperature for present bipolar processes, it is possible if desired to decouple the resistor activation step from the RTA used to set the device electrical parameters.

With the Bipolar and TCRL components processed to this point, it is now appropriate to remove the protection layers from the CMOS portions of the wafer so that the remaining metalization operations can be performed on all devices. Turning next to Figure 16, the TCRL resistor 141 and the NPN transistor regions 200 are protected with a layer of photoresist 160. The photoresist is patterned to open a region above the CMOS devices 100. Next, the protective oxide 92 (Fig. 15) is removed.

Now refer to Figure 17. The photoresist layer 160 is removed, followed by removal of the nitride protect layer 90. At this time, the emitter 170 and the resistor 141 are subjected to an RTA step. The step is carried out at approximately 900°C for 0.5 minutes, and completes the fabrication of the emitter first prepared in the steps shown previously in Figure 13.

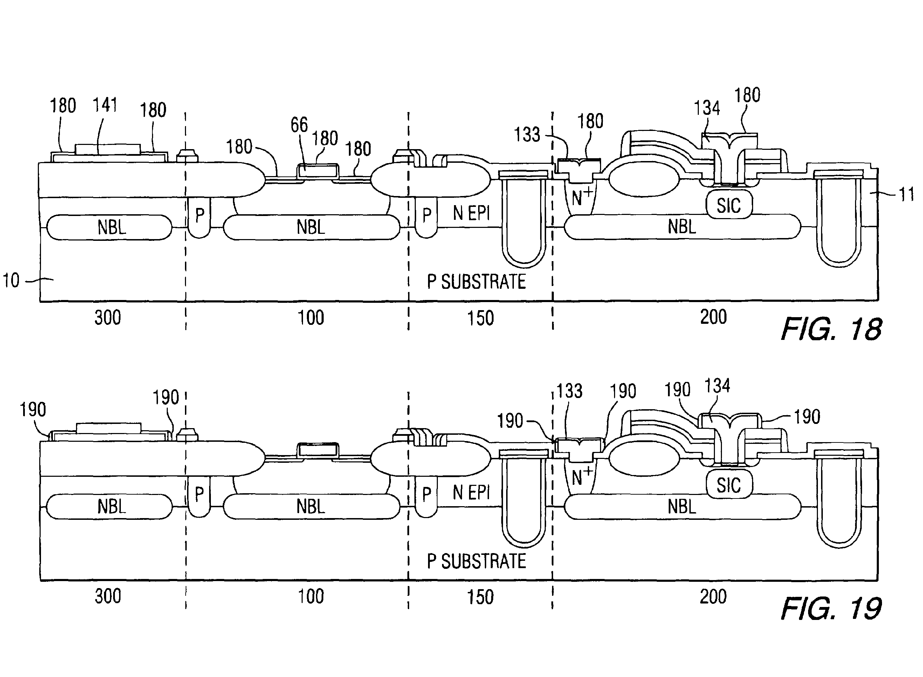

The screen oxide layer 80 over the lightly doped source and drain regions of the CMOS device is then removed. As shown in Figure 18, the exposed polysilicon regions of the resistor 141, the gate 66, the source and drain regions, and the collector and emitter contacts 133, 134 are silicided with platinum 180 to form a platinum silicide layer on the exposed polysilicon. As shown in Figure 19, a sidewall spacer oxide 190 is applied to the sidewalls of the emitter contact 134 and the collector contact 133. The rest of the spacer oxide is etched and removed, Thereafter, the substrate is subjected to suitable metallization layers, including the formation of three metal layers separated from each other by suitable insulating layers and separate layers being selectively interconnected, one to the other, by the formation of vias that are filled with conductive material. After metallization the entire device is covered with a passivation layer, typically silicon nitride, and a substrate including the integrated circuits and devices made thereon are then further processed for testing and assembly.

A low temperature coefficient resistor (TCRL) has some unrepaired ion implant damage. The damaged portion raises the resistance and renders the resistor less sensitive to operating temperature fluctuations. A polysilicon thin film low temperature coefficient resistor and a method for the resistor's fabrication overcomes the coefficient of resistance problem of the prior art, while at the same time eliminating steps from the BiCMOS fabrication process, optimizing bipolar design tradeoffs, and improving passive device isolation. A low temperature coefficient of resistance resistor (TCRL) is formed on a layer of insulation, typically silicon dioxide or silicon nitride, the layer comprising polysilicon having a relatively high concentration of dopants of one or more species. An annealing process is used for the implanted resistor which is shorter than that for typical prior art implanted resistors, leaving some intentional unannealed damage in the resistor. The planned damage gives the TCRL a higher resistance without increasing its temperature coefficient. A process for fabrication of the resistor is used which combines separate spacer oxide depositions, provides buried layers having different diffusion coefficients, incorporates dual dielectric trench sidewalls that double as a polish stop, supplies a spacer structure that controls precisely the emitter-base dimension, and integrates bipolar and CMOS devices with negligible compromise to the features of either type.

## Claims

1. A process for making a polysilicon precision resistor in a integrated circuit comprising the steps of:
depositing an insulating layer on the integrated circuit;
depositing a polysilicon layer on the insulating layer;
implanting ions into the polysilicon layer to change the resistance of the polysilicon and to damage the polysilicon layer;
controlling the annealing of the polysilicon layer to reduce temperature coefficient of resistance of the polysilicon resistor, in which the annealing temperature ranges from 900 degrees C to 800 degrees C.

2. The method of claim 1 wherein the implant energy of the ions ranges from 10 to 5KeV.

3. The method of claim 1 wherein the thickness of the polysilicon layer ranges from 65nm to 75nm.

4. The method of claim 1 wherein two or more species of ion are implanted into the polysilicon.

5. The method of claim 1 wherein boron is one of the species.

6. A process for forming an integrated circuit with MOS and bipolar devices in a semiconductor substrate, comprising:
forming a trench in the substrate to separate bipolar from MOS regions;
forming one or more local oxidation regions in the surface of the semiconductor to surface isolate NMOS from PMOS devices and to surface separate collector regions from emitter and base regions;
depositing an oxide layer over the substrate;
masking and patterning the deposited oxide layer to form sidewall spacers on edges of gates of MOS devices and protecting the bipolar region from damage during formation of MOS devices; and
after substantially completing the formation of MOS devices, further patterning the remaining spacer oxide layer to define openings for collector contacts and to define base and emitter regions.

7. The method of claim 6 including the step of implanting the source and drains of the MOS devices and using the sidewall spacers on the edges of the gates to self align the sources and drains.

8. A process for forming an integrated circuit with MOS device regions and bipolar device regions in a semiconductor substrate, comprising:
forming a trench in the substrate to separate bipolar from MOS regions;
forming one or more local oxidation regions in the surface of the semiconductor to surface isolate NMOS from PMOS devices and to surface separate collector regions from emitter and base regions;
substantially completing the formation of MOS devices;
covering the substrate with a layer of silicon nitride;
covering the layer of silicon nitride with a layer of deposited oxide;
forming bipolar devices while maintaining the integrity of the silicon nitride and deposited oxide layers over the CMOS device regions and selectively removing one or more portions of the silicon nitride and deposited oxide layers over the bipolar device regions.

9. A process for forming an integrated circuit with MOS and bipolar devices in a single semiconductor substrate, comprising;
forming a first buried layer with a mask;
forming a second buried layer with a second dopant having a second diffusion coefficient beneath the other of the MOS or bipolar devices;
selectively implanting one or more collectors of the bipolar devices to provide an integrated circuit with two or more bipolar devices with different doping profiles.

10. The process of claim 9 wherein said dual buried layer is doped as N-type, or said dual buried layer is doped as P-type.

11. The process of claim 9 wherein said two or mor bipolar devices are created as NPN.

12. The process of claim 9 wherein said two or mor bipolar devices are created as PNP.

13. A process for forming an integrated circuit with MOS and bipolar devices in a single semiconductor substrate, comprising;
depositing a trench mask pattern on the surface of the semiconductor substrate;
etching a trench pattern into the surface of the semiconductor substrate;
depositing a first dielectric material on the sidewall of the trench, said first dielectric material having a thermal coefficient of expansion close to the thermal coefficient of expansion of the semiconductor material;
deposing a second dielectric material on the first dielectric material; and filling said trench structure with polysilicon.

14. The process of claim 13 including the step of forming a trench protection region above said trench structure.

15. The process of claim 13 wherein the semiconductor material is silicon, the first dielectric is silicon nitride and the second dielectric is silicon dioxide.

16. The process of claim 13 including the step of polishing the surface and stopping the polishing when the silicon nitride is exposed.

17. The process of claim 13 wherein the second dielectric is deposited on the surface of the semiconductor wafer and comprises a pad oxide and the further step of pattering the pad oxide and locally oxidizing the surface of the semiconductor wafer.

18. The process of claim 13 wherein one or more voids are left unfilled in the polysilicon filling said trench to provide stress relief and eliminate silicon defect generation.

19. The process of claim 13 wherein said trench protection region is formed using a local oxidation of silicon skin oxide as a patterned hard mask for wet nitride etch.

20. A process for forming an integrated circuit with MO and bipolar devices in a single semiconductor substrate, comprising;
depositing a patterning a gate layer to form a gate over each MOS device;
forming a spacer oxide layer over the entire substrate;
removing the layer from over the MOS devices to protect the bipolar devices during processing of the MOS devices;
etching the exposed spacer layer to leave sidewall spacers on the sides of the gates of the MOS devices;
implanting regions of the MOS devices adjacent the sidewall spacers to form self-aligned sources and drains of said MOS devices;
depositing a collector and emitter mask over the bipolar devices;
etching the spacer layer to expose collector and emitter regions;
using the remaining spacer layer as a mask, doping the exposed collector and emitter regions to form collectors and emitters for the bipolar devices.

21. The process of claim 20 including the step of forming an extrinsic base for said bipolar devices;
forming a spacer structure for said bipolar transistor to provide control of critical emitter and base dimensions;
forming an emitter polysilicon layer to form the contact for said emitter.

22. The process of claim 20 wherein forming said extrinsic base further comprises the steps of forming a doped polysilicon layer, a tungsten silidde layer, a polysilicon cap layer, an interpoly oxide layer, and an anti-reflective coating layer.
